# EUROPEAN PATENT SPECIFICATION

(11) **EP 0 443 884 B1**
(45) Date of publication and mention of the grant of the patent: **24.07.1996**
(21) Application number: 91301537.6
(22) Date of filing: 25.02.1991
(51) Int. Cl.: H03G 3/00

(54) **Signal processing apparatus**
Vorrichtung zur Signalverarbeitung
Appareil de traitement du signal

(30) Priority: 23.02.1990 GB 9004148
(43) Date of publication of application: 28.08.1991
(73) Proprietor: QUESTECH LIMITED, Wokingham Berkshire RG11 2PP (GB)
(72) Inventor: Wells, Mervyn, Reading, Berks. RG1 7YT (GB); Shuttleworth, Tim, Reading, Berks. RG5 3RZ (GB)
(74) Representative: Bubb, Antony John Allen

(56) References cited:
- EP-A- 0 100 408
- AU-B- 0 584 311
- FR-A- 2 458 178
- US-A- 4 611 344
- US-A- 4 959 867
- ELECTRONIC DESIGN NEWS, vol. 31, no. 2, January 1986, pages 214-217, Boston,US; M. BILAC: "Program returns D/A input for new gain"

## Description

This invention concerns improvements in signal processing apparatus. It is an object of the invention to make use of digital signal processing techniques in order to enable an analogue input signal provided from a variable control means to be processed in order to provide an output signal having a wider range of variation and/or a greater resolution than is capable of being provided by the analogue control means alone.

An example of a conventional technique is shown in FR-A-2 458 178.

In accordance with the invention there is provided a signal processing system comprising a control means adjustable to provide an analogue output signal that can be varied continuously within a given range, an analogue to digital converter arranged to receive said analogue signal as an input and to output a corresponding signal in digital form, and a signal processor arranged to receive said digital signal, the said signal processor being so organised that it can provide an output signal falling within any one of a plurality of individual ranges of signal values, the limits of which ranges are defined in such a manner that, collectively, said ranges provide a set of values extending between limits greater than any individual one of said ranges, and the said signal processor further being so organised that the relative value of said output signal within any one of said ranges is determined by the value of said analogue input signal within a first predetermined range of values, whilst selection of that one of said ranges within which the output signal is to fall can be effected by adjustment of said control means to provide an analogue input signal lying outside said first, predetermined range of values.

With an arrangement in accordance with the invention, a flexible control of an output signal can be performed by means of an analogue control means having a relatively limited, or coarse range of adjustment. Such a control means may, for example, comprise a manually controllable rotary potentiometer.

The invention is illustrated by way of example in the accompanying drawings, in which:
Figure 1 is a diagrammatic view of the knob of a rotary potentiometer illustrating its range of adjustment and arcs of movement within said range corresponding to particular control functions in an apparatus according to the invention,
Figure 2 is a block circuit diagram of a signal processing apparatus shown together with diagrams indicating the method of operation thereof, and
Figure 3 is a flow chart illustrating the steps of a process that a microprocessor of the apparatus of Fig.2 is programmed to perform.

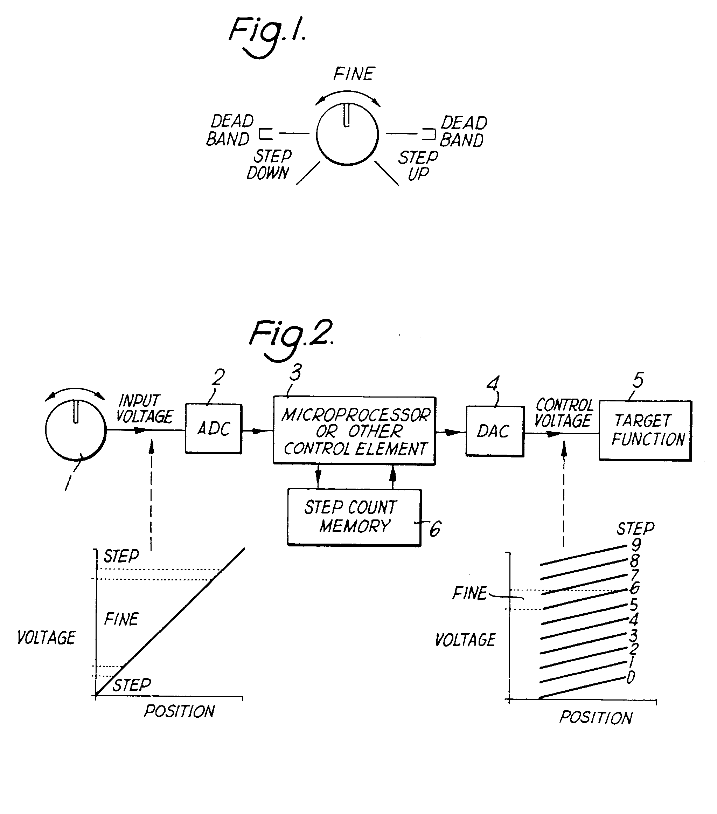

Referring to Fig.2 of the drawings, an apparatus in accordance with the invention comprises a rotary potentiometer having a manual control knob 1, the potentiometer being arranged to provide an input voltage to an analogue to digital converter 2 which in turn provides a digital input signal to a microprocessor or other digital processing system 3. An output of the microprocessor is provided to a digital to analogue converter 4 which in turn provides a controlled output voltage representing a target function to be achieved by manipulation of the control knob 1, and indicated diagrammatically at 5.

The principle of operation of the system illustrated requires the logical separation of the total controllable range of the function into a fine continuous range and a coarse range of large steps. This may be produced by design of the hardware into two distinct ranges, or by assuming a coarse step size for a single wide-range function. Best results are achieved with a fine range approximately 50% larger than the coarse step size. Likewise, the digital values read from the analogue to digital converter 2 are split up into three active regions, with dead-bands to allow for noise and end-of-range settings. A typical format for the input knob range is shown in Fig.1.

When input values from the analogue to digital converter 2 are in the central fine band area, the controlling element of the system scales the range of the potentiometer position down to give a very fine range of control about the centre position. A combination of this fine range and a coarse step position held in a memory 6 is outputted via the digital to analogue converter 4 to the hardware, as the function 5. An input in either of the dead band areas is ignored, thus leaving the hardware in its last updated state for noise immunity.

From the diagram associated with Fig.2, it can be seen that the change in input voltage produces a change in output level that is much reduced, hence the input sensitivity is multiplied up by the total number of available steps minus some loss factor from overlap of the fine ranges. This allows a low resolution analogue to digital converter 2 to be used to control a function which requires a high degree of resolution.

The microprocessor 3 may be programmed with various algorithms to achieve the desired user interface. An easy to use control will auto-repeat steps by incrementing or decrementing the step count at preset time intervals while the input is in either step region. This allows quick setting up by stepping quickly to overshoot the desired position and adjusting back over the fine range. The adjusted value of the target function 5 will normally become apparent to the user from measuring equipment that will be used in association with the processing apparatus according to the invention, but, if desired, the microprocessor 3 may also provide an output to an illuminated or other indicator that may provide to the user a visual calibration of one or more steps or ranges of adjustment of the target function 5.

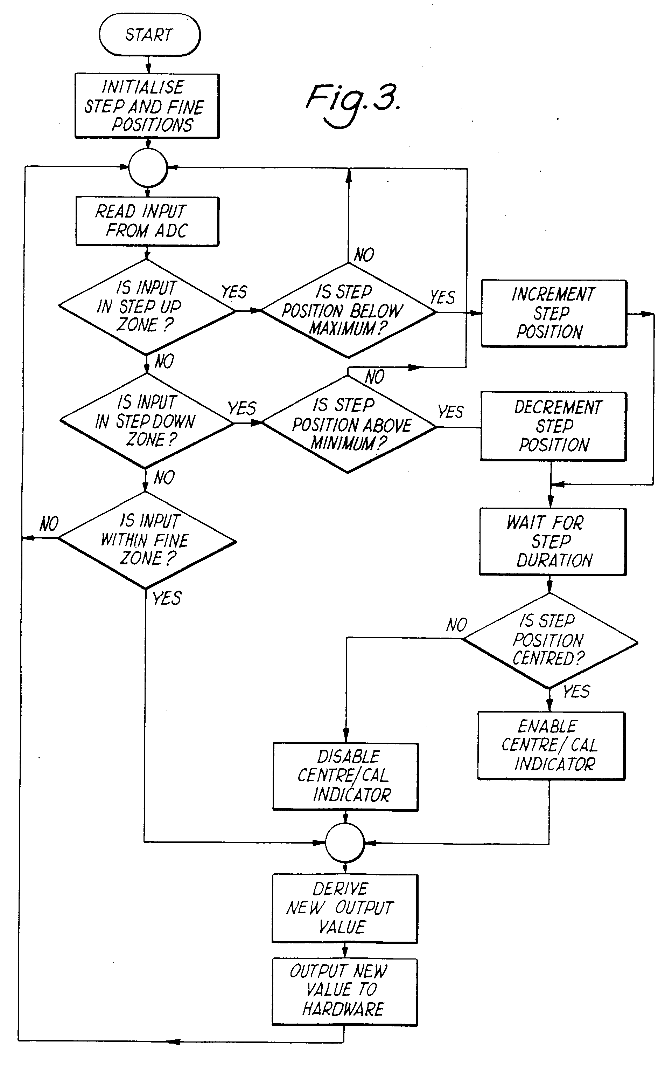

Figure 3 illustrates one suitable algorithm for use in application of an apparatus according to the invention to the controls of a television studio signal synchroniser to gain accurate control of a parameter with a large dynamic range. Such a synchroniser has to be aligned into the studio mixer using two phasing controls whose ratio of 'range' to 'setting' accuracy is of the order of 40,000. To achieve this range on a conventional potentiometer into an analogue to digital converter would have required an expensive ADC of 15 bit resolution and would be very difficult to keep immune to noise. The algorithm implemented expands the dynamic range of the ADC by letting the control programme keep the large significance numbers as the step zones and expanding the intervals to fit the ADC input dynamic range. Thus, the precision is retained by expanding the potentiometer range across the fine zone only enabling small changes in the control output to be achieved by larger changes at the ADC input and hence having good noise immunity.

Accurate setting of the synchroniser phasing is made by examining the video output on standard measurement equipment and adjusting the control potentiometers. For applications where no measurement equipment is present the algorithm may be enhanced by the addition of a centre calibration indicator, which, as indicated in the flow chart, is enabled when the step position is adjusted to the centre of its range. Alternatively, for more accurate setting, the algorithm may be modified to cause the processor to output, to numerical indicators, the level setting as a percentage of the total range.

## Claims

1. A signal processing system characterised in that it comprises a control means (1) adjustable to provide an analogue output signal that can be varied continuously within a given range, an analogue to digital converter (2) arranged to receive said analogue signal as an input and to output a corresponding signal in digital form, and a signal processor (3,6) arranged to receive said digital signal, the said signal processor (3,6) being so organised that it can provide an output signal falling within any one of a plurality of individual ranges of signal values, the limits of which ranges are defined in such a manner that, collectively, said ranges provide a set of values extending between limits greater than any individual one of said ranges, and the said signal processor (3,6) further being so organised that the relative value of said output signal within any one of said ranges is determined by the value of said analogue input signal within a first predetermined range of values, whilst selection of that one of said ranges within which the output signal is to fall can be effected by adjustment of said control means to provide an analogue input signal lying outside said first, predetermined range of values.

2. A system as claimed in Claim 1, characterised in that the said signal processor includes a microprocessor (3) and a memory (6) for storing a value defining that one of said plurality of individual ranges within which said output signal is to fall, said microprocessor is programmed to increment the value contained in said memory (6) at predetermined intervals of time when said digital signal lies within a second predetermined range of values, to decrement the value contained in said memory (6) at predetermined intervals of time when said digital signal lies within a third predetermined range of values, and to provide, as said output signal, a signal having a value calculated from the value contained in said memory taken in conjunction with the prevailing value of said digital signal within said first predetermined range of values.

3. A system as claimed in Claim 1 or 2, characterised in that it further includes a digital to analogue converter for providing an analogue signal from the digital output signal of said processor.

4. A system as claimed in Claim 2 or Claim 3 as appended thereto characterised in that said control means (1) comprises a continuously movable manual control member and that said first, second and third ranges of values correspond to the three separate ranges of movement of said potentiometer.

5. A system as claimed in Claim 4, characterised in that said control means comprises a rotary potentiometer.

6. A system as claimed in Claim 4 or 5, characterised in that said ranges of movement are separated by dead bands.

7. A system as claimed in any preceding claim, characterised in that said signal processor is further organised to control means providing a visual calibration of said output signal.

## Patentansprüche

1. Vorrichtung zur Signalverarbeitung, dadurch gekennzeichnet, daß sie versehen ist mit einer Steueranordnung (1), die einstellbar ist, um ein analoges Ausgangssignal bereitzustellen, das innerhalb eines gegebenen Bereichs kontinuierlich variiert werden kann, mit einem Analog/Digital-Wandler (2), der das analoge Signal als ein Eingangssignal aufnimmt und ein entsprechendes Signal in digitaler Form abgibt, und mit einem Signalprozessor (3, 6), der das digitale Signal aufnimmt und der so organisiert ist, daß er ein Ausgangssignal anliefern kann, das in einen einer Mehrzahl von individuellen Signalwertebereichen fällt, wobei die Grenzen dieser Bereiche derart definiert sind, daß diese Bereiche kollektiv für eine Gruppe von Werten sorgen, die sich zwischen Grenzen erstrecken, die weiter als irgendein einzelner dieser Bereiche sind, und wobei der Signalprozessor (3, 6) ferner so organisiert ist, daß der relative Wert des Ausgangssignals innerhalb eines beliebigen dieser Bereiche durch den Wert des analogen Eingangssignals innerhalb eines ersten vorbestimmten Wertebereichs bestimmt ist, während eine Auswahl desjenigen dieser Bereiche, in welchen das Ausgangssignal fallen soll, durch Einstellung der Steueranordnung bewirkt werden kann, um analoges Eingangssignal bereitzustellen, das außerhalb des ersten vorbestimmten Wertbereichs liegt.

2. Vorrichtung nach Anspruch 1, dadurch gekennzeichnet, daß der Signalprozessor einen Mikroprozessor (3) und einen Speicher (6) zum Speichern eines Wertes aufweist, der denjenigen der Mehrzahl von individuellen Bereichen definiert, in den das Ausgangssignal fallen soll, wobei der Mikroprozessor so programmiert ist, daß er den in dem Speicher (6) enthaltenen Wert in vorbestimmten Zeitintervallen inkrementiert, wenn das digitale Signal innerhalb eines zweiten vorbestimmten Wertebereichs liegt, daß er den in dem Speicher (6) enthaltenen Wert in vorbestimmten Zeitintervallen dekrementiert, wenn das digitale Signal innerhalb eines dritten vorbestimmten Wertebereichs liegt, und daß er als das Ausgangssignal ein Signal anliefert, das einen Wert hat, der aus dem in dem Speicher enthaltenen Wert in Verbindung mit dem vorherrschenden Wert des digitalen Signals innerhalb des ersten vorbestimmten Wertebereichs errechnet ist.

3. Vorrichtung nach Anspruch 1 oder 2, dadurch gekennzeichnet, daß sie ferner einen Digital/Analog-Wandler zum Bereitstellen eines analogen Signals ausgehend von dem digitalen Ausgangssignal des Prozessors aufweist.

4. Vorrichtung nach Anspruch 2 oder 3, dadurch gekennzeichnet, daß die Steueranordnung (1) ein kontinuierlich verstellbares manuelles Steuerglied aufweist, und daß der erste, zweite und dritte Wertebereich den drei gesonderten Verstellbereichen des Potentiometers entsprechen.

5. Vorrichtung nach Anspruch 4, dadurch gekennzeichnet, daß die Steueranordnung ein Dreh-Potentiometer aufweist.

6. Vorrichtung nach Anspruch 4 oder 5, dadurch gekennzeichnet, daß die Verstellbereiche durch Totzonen getrennt sind.

7. Vorrichtung nach einem der vorhergehenden Ansprüche, dadurch gekennzeichnet, daß der Signalprozessor ferner so organisiert ist, daß er eine Anordnung steuert, die für eine visuelle Eichung des Ausgangssignals sorgt.

## Revendications

1. Système de traitement de signal, caractérisé en ce qu'il comprend des moyens de commande (1) réglables pour fournir un signal de sortie analogique que l'on peut faire varier en continu à l'intérieur d'une plage donnée, un convertisseur analogique-numérique (2) agencé pour recevoir ledit signal analogique sous forme d'entrée et pour délivrer un signal correspondant sous forme numérique, et un processeur de signal (3, 6) agencé pour recevoir ledit signal numérique, ledit processeur de signal (3, 6) étant organisé de telle façon qu'il peut fournir un signal de sortie s'inscrivant à l'intérieur d'une plage quelconque parmi une pluralité de plages individuelles de valeurs de signal, les limites de ces plages étant définies de telle façon que, collectivement, lesdites plages fournissent une série de valeurs s'étendant entre des limites plus grandes que n'importe quelle plage individuelle parmi lesdites plages, et ledit processeur de signal (3, 6) étant en outre organisé de telle façon que la valeur relative dudit signal de sortie à l'intérieur de l'une quelconque desdites plages est déterminée par la valeur dudit signal d'entrée analogique à l'intérieur d'une première plage prédéterminée de valeurs tandis que la sélection, parmi lesdites plages, de la plage à l'intérieur de laquelle le signal de sortie doit s'inscrire peut être effectuée par l'ajustement desdits moyens de commande pour fournir un signal d'entrée analogique situé à l'extérieur de ladite première plage prédéterminée de valeurs.

2. Système selon la revendication 1, caractérisé en ce que ledit processeur de signal comprend un microprocesseur (3) et une mémoire (6) pour stocker une valeur définissant, parmi ladite pluralité de plages individuelles, la plage à l'intérieur de laquelle ledit signal de sortie doit s'inscrire, ledit microprocesseur étant programmé pour incrémenter la valeur contenue dans ladite mémoire (6) à des intervalles de temps prédéterminés quand ledit signal numérique est situé à l'intérieur d'une deuxième plage prédéterminée de valeurs, pour décrémenter la valeur contenue dans ladite mémoire (6) à des intervalles de temps prédéterminés quand ledit signal numérique est situé à l'intérieur d'une troisième plage prédéterminée de valeurs et pour fournir, à titre dudit signal de sortie, un signal ayant une valeur calculée à partir de la valeur contenue dans ladite mémoire prise en conjonction avec la valeur qui prévaut dudit signal numérique à l'intérieur de ladite première plage prédéterminée de valeurs.

3. Système selon la revendication 1 ou 2, caractérisé en ce qu'il comprend en outre un convertisseur numérique-analogique pour fournir un signal analogique à partir du signal de sortie numérique dudit processeur.

4. Système selon la revendication 2 ou 3 telle qu'elle est présentée en annexe ici, caractérisé en ce que lesdits moyens de commande (1) comprennent un élément de commande manuelle mobile en continu et en ce que lesdites première, deuxième et troisième plages de valeurs correspondent aux trois plages séparées de mouvement dudit potentiomètre.

5. Système selon la revendication 4, caractérisé en ce que lesdits moyens de commande comprennent un potentiomètre rotatif.

6. Système selon la revendication 4 ou 5, caractérisé en ce que lesdites plages de mouvement sont séparées par des bandes d'insensibilité.

7. Système selon l'une quelconque des revendications précédentes, caractérisé en ce que ledit processeur de signal est en outre organisé pour commander des moyens fournissant un étalonnage visuel dudit signal de sortie.
